# EUROPEAN PATENT SPECIFICATION

(11) **EP 2 875 170 B1**
(45) Date of publication and mention of the grant of the patent: **31.10.2018**
(21) Application number: 13739690.9
(22) Date of filing: 19.07.2013
(51) Int. Cl.: C23C 28/00, C23C 28/02, B32B 15/01, H01L 21/443, H01R 4/58, H01R 13/03

(54) **COATING PROCESS FOR PRESS-FIT CONTACT**
BESCHICHTUNGSVERFAHREN FÜR EINEN PRESSKONTAKT
PROCÉDÉ DE REVÊTEMENT POUR CONTACT AJUSTÉ PAR PRESSION

(30) Priority: 20.07.2012 FR 1257093
(43) Date of publication of application: 27.05.2015
(73) Proprietor: Tyco Electronics France SAS, 95300 Pontoise (FR)
(72) Inventor: BEDNAREK, Alain, F-95640 Neilly en Vexin (FR)
(74) Representative: Grünecker Patent- und Rechtsanwälte PartG mbB
(86) International application number: PCT/EP2013/065286
(87) International publication number: WO 2014/013055

(56) References cited:
- WO-A1-97/22472
- DE-A1-102007 047 007
- DE-A1-102010 042 526
- DE-B3-102010 040 469
- US-B1- 6 183 886
- US-B1- 6 596 621

## Description

The present invention relates to the prevention of the formation of whiskers on the surface of metallic layers used for the plating of elements of press-fit contacts.

The formation of filaments or whiskers, particularly from the surface of a pure metal (for example tin, zinc, cadmium, indium, antimony, silver or gold, as opposed to an alloy composed of at least one metal and another element) is a known phenomenon which can have consequences such as the production of short-circuits or the initiation of electrical arcs at the surface of the metallic layers used for the plating of contacts of electronic components.

Certain factors such as mechanical or chemical stresses, scratches, diffusion of different materials, or thermal expansion increase the risk of whisker formation. Contrarily to dendrites, another phenomenon appearing at the surface of certain metals, the dissolution of the metal or the presence of electromagnetic fields do not have an effect on the formation or the growth of the whiskers.

The contacts of electronic components are generally composed of a base substrate, for example copper, plated with a metallic coating, of which pure tin (as opposed to a tin alloy) is one of the most frequently used. This is the case particularly for press-fit contacts. In the case of such contacts made of copper plated with pure tin, in addition to the stresses inherent in the coating layer or in the substrate itself, compression stresses in the plating able to lead to the formation of whiskers are due to the diffusion of copper atoms from the substrate along the boundaries of the grains of the tin film, forming an intermetallic compound, or IMC, Cu₆Sn₅. Under such stresses, the tin whiskers can then be formed from grains the orientation of which differs from the major orientation of the tin film or from the orientation of the adjacent grains.

One way of dealing with the problem of the tin whiskers consisted in the use of platings made of alloys of tin and lead. However, since lead is currently banned for the majority of electronic applications, particularly in the European Union, incidents due to the formation of whiskers in the electronic components have again become common. It is therefore necessary to find novel solutions for the prevention of the formation of the whiskers, particularly on the contacts of electronic elements.

The problem of the tin whiskers formed on elements of press-fit contacts is for example known from document EP 2 195 885 B1, which discloses a process for manufacture of an electrical contact element using a layer forming a diffusion barrier applied on a base material, on which is then applied a plurality of a combination of at least two metallic layers formed of different metals and at least one of which is made of tin. The layer forming a diffusion barrier prevents mixture between the base material and the layers of the combination of metallic layers, which are then subjected to a thermal treatment, the temperature of which must not exceed the melting temperature of the tin, i.e. 232 °C, so that the elements of the combination of metallic layers mix by diffusion, the outer layer then being an alloy comprising at least two different metals.

Other solutions are also known in the state of the art, for example from WO 2006/134665 A1, which use a nickel sub-layer between the copper-based substrate and the tin plating film in order to reduce the stresses applied to the layer of tin by the intermetallic compound Cu₆Sn₅ by creating a denser intermetallic compound Ni₃Sn₄. A thermal treatment not exceeding 0.65 to 0.8 times the melting temperature of the grains can be applied in order to reduce the internal stresses of the coating. Another example is disclosed in US6183886.

These solutions are difficult to implement and the production of coatings is not financially viable due to the duration and cost of the processes used. Due to the stresses and therefore to the permanent stresses applied to the ends of the press-fit contact pins by the printed circuit boards and deformations and displacements of the coating itself, these solutions are insufficient to avoid the formation of whiskers in the case of press-fit contacts.

An objective of the present invention is therefore to provide a solution particularly permitting improvement of the existing plating processes, particularly within the context of press-fit contacts, particularly by avoiding the formation of whiskers.

According to one aspect of the present invention, this objective is attained by a process for coating of a substrate, in which: a substrate is provided having at least one free surface; a first layer of a first material is deposited on the free surface of the substrate; a second layer of a second material, different from the first material, is deposited on the first layer; a third layer of a third material, different from the first and second materials, is deposited on the second layer. According to one aspect of the invention, the process comprises in addition the deposition of a protective layer of a fourth material, different from the first, second and third materials, on the third layer; and the reflow of at least the second and third layers of the first, second and third layers, by heat transfer by thermal contact on the protective layer, the protective layer avoiding oxidation at least of the third layer.

The present invention uses a high-temperature reflow applied to a multi-layer surface treatment of a substrate or base material and makes it possible to prevent the formation and diffusion of whiskers at the surface of the coating. The first layer is used as a diffusion barrier layer. The invention is distinguished from the known state of the art particularly by the steps of deposition of a protective layer against oxidation and by the reflow step which requires higher temperatures than the melting point of the element forming the third layer, which is the outer layer of the coating. The temperature of the reflow step must be as high as possible in order to have a quick reflow process and relaxation of the stresses on the substrate. This high-temperature process uses the transfer of heat by thermal contact on the outer surface of the product, i.e. the protective layer. Depending on the thickness of the first, second and third layer, the temperature and the duration of the reflow, it is possible to partially or totally reflow the third layer with at least a part of the second layer. Similarly, it is also possible to at least partially reflow the first layer, i.e. the layer forming the diffusion barrier at the surface of the substrate. It is therefore possible by means of the invention to form a multiphase solidification structure containing precipitates able to block the movement of the dislocations, and therefore a multiphase alloy which has the advantage of preventing the formation of whiskers and is therefore suitable for the plating of contact elements of printed circuits. The multiphase alloy obtained can in addition have thixotropic properties, i.e. be able, under stress, to pass from the solid state to the liquid state, and conversely, at rest, it restructures itself to recover its solid appearance while retaining its properties and advantages on destructuring or restructuring. This property is useful within the context of coatings of press-fit contacts. The inventive process in addition advantageously permits relaxation of the internal stresses and stabilisation of the metallurgical structure of a press-fit contact and of its coating in order to guarantee its performance. In particular, the inventive process has the advantage of stabilising the insertion forces of the contact in the corresponding hole of a printed circuit during the lifetime of the product.

The material of the protective layer is so selected that it does not mix with the first, second and third layers during the reflow step. Thus the reflow of the layers forming the plating can be effected in controlled and efficient manner.

Preferably, the temperature of the reflow step can be 1.5 to 3 times higher than the melting temperature of the third material, 0.8 to 1.5 times higher than the melting temperature of the second material, and can be less than or equal to the melting temperature of the first material and/or of the substrate. The temperature of the reflow step can thus be fairly high in order to have a quick reflow process and relaxation of the stresses on the substrate.

According to a preferred embodiment, the first, second and third materials can be or can comprise metallic materials, particularly elementary metals. The invention therefore has the advantage of being able to be used for metallic coatings, for example in the case of platings of electronic components such as contacts of printed circuit elements, using alloys, but also and preferably pure or elementary metals. These latter can be advantageous in the case of the plating of press-fit contact elements having to be subject to high mechanical stresses and for which it is necessary to avoid the formation of whiskers.

Advantageously, the third material can be the material having the lowest melting point of the melting points of the first, second and third materials. Thus the reflow step is initiated by the melting of the third layer and/or of the interface between the third and the second layer.

Advantageously, the second material can have a melting temperature 1.5 to 3 times greater than that of the third material. A second layer selected from such a material relative to the material of the third layer makes it possible to control the reflow and partially or fully reflow the third layer with the second layer, always starting with the reflow of the third layer.

Advantageously, the substrate and/or the first material can have a melting temperature at least 2 to 3 times higher than the melting temperature of the second material. Thus the melting temperature of the substrate and/or of the first material is not reached during the reflow step, which avoids the diffusion of these materials towards the surface of the coating, i.e. towards the third layer.

Advantageously, the fourth material, i.e. the material forming the protective layer, can have a specific heat 2 to 3 times higher than that of the second and third materials. The fourth material can therefore be so selected as to optimise the heat transfer by thermal contact during the reflow step.

In an example of an embodiment of this aspect of the present invention, the first material can be or can comprise nickel, and/or the second material can be or can comprise zinc or antimony, and/or the third material can be or can comprise tin and/or silver. In the case of a standard plating using pure tin, it is advantageous to use a barrier layer made of nickel, followed by a layer of zinc and by the layer of tin. The invention then permits the complete recrystallisation of the tin alloy using the starting point of the interface between the layer of zinc and the layer of tin, which has the lowest melting point. It is therefore possible to initiate the reflow at the interface between the layers of tin and of zinc, and to also reflow the surface of the layer of tin before the solid-solid diffusion of the zinc. The layers of tin and of zinc can be partially or wholly reflowed, as required. It is therefore possible to create a smooth, non-porous and hardened surface, while controlling a residual buffer sub-layer of zinc, and having a solidification structure filled with a precipitate preventing the dislocation movements of the grains which could create whiskers. By means of the inventive process, it is therefore possible to remove or lessen the stresses which create the whiskers with a reduced cost and process time relative to those of the known processes of the state of the art.

The buffer layer of zinc and the diffusion barrier layer of nickel are advantageous for the prevention of the formation of tin whiskers at the surface of the coating, which finds an application particularly in the case of press-fit contacts for printed circuits. Contrarily to the known processes of the state of the art for the prevention of whiskers, the process according to the invention does not create solid-solid diffusion, but takes advantage of the solid-liquid diffusion of the zinc or of the tin and of the zinc in order to accelerate the process. Once the reflow step has been performed, the final coating has proved effective in preventing the formation and the growth of tin whiskers. In the case of a plating using pure silver, it can be advantageous to use antimony instead of zinc. Nevertheless, other combinations of metals are possible, provided that these combinations permit the reflow of the second and third layer according to the different aspects of the invention. Particularly, other combinations of materials are possible for the different layers provided that they follow the advantageous modified embodiments of the invention relating to melting temperatures and to specific heats.

Preferably, the fourth material can be a mixture of graphite powder comprising microcrystalline active carbon, particularly a mixture composed of 80% to 100% of graphite and the remainder of microcrystalline active carbon, more particularly a mixture composed of 90% of graphite and of 10% of microcrystalline active carbon. The use of the graphite powder, particularly the mixtures comprising graphite powder and crystalline active carbon, have proved particularly effective for protection against oxidation of the layers of pure metals used for the plating of contact elements for printed circuits. Indeed, the graphite powder can be selected because it is a conductor of heat due to its higher specific heat relative to the elements of the first, second and third layers. The mixture comprising 90% of graphite and 10% of microcrystalline active carbon has proved advantageous in the production of a coating which prevents the formation of tin whiskers in the case in which the first material is nickel, the second material is zinc, and the third material is tin.

According to an advantageous embodiment, the temperature of the reflow step can be at least 350 °C, particularly it can be within the range from 350 °C to 600 °C, more particularly within the range from 380 °C to 580 °C, and still more particularly it can be within the range from 400 °C to 550 °C. These temperature ranges are suited particularly to the treatment of pure tin coatings accompanied by a sub-layer of zinc and a layer of nickel forming a diffusion barrier on a base substrate of copper.

According to an advantageous embodiment, the duration of the reflow step can vary at least between 1 second and 15 seconds, particularly between 2 seconds and 10 seconds, and more particularly between 3 seconds and 7 seconds. The use of a protective layer comprising a mixture of graphite with a high specific heat permits performance of the steps of the inventive process in a reliable manner over a duration within this range of durations. The invention, particularly in the presence of a protective layer against oxidation, therefore has the advantage of permitting a quicker treatment than the known coating processes of the state of the art at least in the case of tin or silver platings the thermal treatment steps of which last up to several hours.

In an example of an embodiment of this aspect of the present invention, the thickness of the first layer can be within the range from 0.05 µm to 5 µm and/or the thickness of the second layer can be within the range from 0.05 µm to 5 µm, and/or the thickness of the third layer can be within the range from 0.05 µm to 2.5 µm. These ranges of thickness of the layers are advantageous for obtaining multiphase structures preventing the formation of whiskers, particularly in the case of platings of tin or silver used on contacts of printed circuit elements, particularly for press-fit contacts. Depending on the deposited thicknesses of the second and third layers, the reflow process defined inter alia by its duration and its temperature permits the production of a set of choices of whisker-preventing solidification structures, adjustable in terms of structure, texture, composition, roughness, etc.. It is therefore possible to obtain, depending on the selected starting parameters, for example a globular biphase tin-zinc structure resting on a buffer layer of reduced zinc, or a polyphase tin-zinc-nickel structure without a buffer layer of zinc, or a globulo-acicular biphase tin-zinc structure on a large buffer layer of zinc. A continuous process will in addition permit shorter treatment durations than those known in the state of the art for the deposited thicknesses and the applied temperatures selected. In the case of the plating of the contact terminals of electronic components, it is therefore possible to select suitable solidification structures depending on the finish of the printed circuit on which these contacts will be inserted.

Advantageously, the process can in addition comprise the removal of the protective layer after the reflow step. In many applications, the protective layer may therefore not form part of the final coating resulting from the process according to the invention, and it is therefore necessary to remove it in order to obtain the final product or in order to further treat the surface of the coating obtained by the inventive process. When the protective layer comprises a mixture of graphite powder, after the reflow step it is possible to remove this layer for example by breaking it off or by disintegrating it.

According to another aspect of the present invention, the objective is attained by a coating for an embeddable metallic element comprising a diffusion barrier layer and a multiphase solidification structure layer composed of an alloy of at least two metals and having thixotropic properties. Such a coating for an embeddable metallic element can in addition comprise a buffer layer between the diffusion barrier layer and the solidification structure layer. The objective is moreover also attained by a coating for an embeddable metallic element manufactured according to the process according to the first aspect of the present invention.

Preferably, the solidification structure can comprise zinc and tin in the proportions from 85% to 95% by mass of tin deposited for 5% to 15% by mass of zinc deposited, particularly 90% by mass of tin deposited for 10% by mass of zinc deposited, or from 5% to 15% by mass of tin deposited for 85% to 95% by mass of zinc deposited, particularly 10% by mass of tin deposited for 90% by mass of zinc deposited, or from 42% to 52% by mass of tin deposited for 58% to 48% by mass of zinc deposited, particularly 47% by mass of tin deposited for 53% by mass of zinc deposited, or from 69% to 79% by mass of tin deposited for 21% to 31% by mass of zinc deposited, particularly 74% by mass of tin deposited for 26% by mass of zinc deposited, or from 18% to 28% by mass of tin deposited for 72% to 82% by mass of zinc deposited, particularly 23% by mass of tin deposited for 77% by mass of zinc deposited.

The objective is also attained by a press-fit contact pin plated with a coating for an embeddable metallic element according to one of the preceding aspects of the invention, particularly by a coating manufactured by a process according to the first aspect of the invention. The objective is also attained by a printed circuit press-fit contact hole plated with a coating for an embeddable metallic element according to one of the preceding aspects of the invention, particularly by a coating manufactured by a process according to the first aspect of the present invention. It is therefore possible, as required, to use the inventive plating or coating either on the pin of a press-fit contact, or on the hole in the printed circuit board receiving this pin, or on both.

Finally, the objective is also attained by a printed circuit board or a printed circuit comprising at least one element plated with a coating for an embeddable metallic element according to one of the preceding aspects, particularly by a printed circuit comprising at least one element plated with a coating manufactured by the process according to the first aspect of the invention.

Printed circuit elements using a coating according to one of the aspects of the invention are advantageous relative to elements using known coatings of the state of the art because the coatings according to the aspects of the invention and its modified embodiments make it possible to prevent, or even totally avoid the formation of whiskers. Moreover, the use of a coating according to the invention on printed circuit elements advantageously permits relaxation of the internal stresses and stabilisation of the metallurgical structure of the elements and their coating in order to guarantee their performance. Particularly, the insertion forces of press-fit contacts in corresponding holes of printed circuits are stabilised for the lifetime of the product.

The invention will be described in detail in what follows using examples of embodiments shown by the following figures:
- Figure 1: showing a first example of an embodiment of the invention;
- Figure 2: showing a second example of an embodiment of the invention;
- Figure 3: showing a third example of an embodiment of the invention.

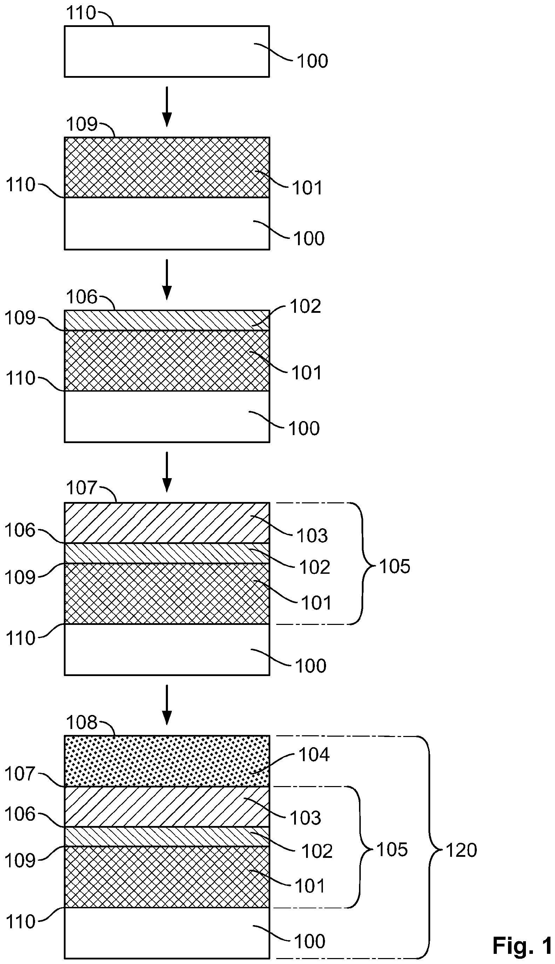

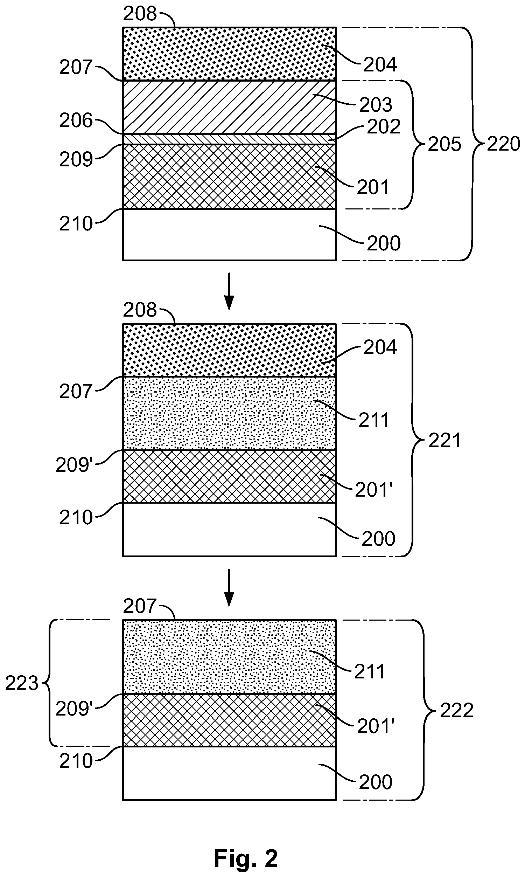

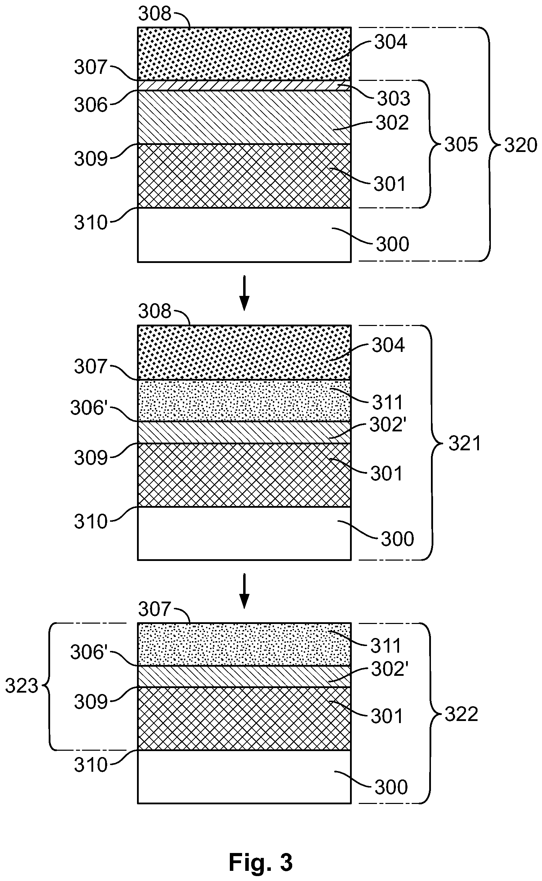

Figures 1 to 3 use similar reference signs for identical elements or elements playing a similar role. Thus, for example, element 108 on Figure 1 is identical or plays the same role as elements 208 and 308 on Figures 2 and 3, respectively.

Figure 1 shows an example of an embodiment of a process for coating a substrate 100. The example process shown in Figure 1 generally describes the main steps and characteristics of a process for coating a base substrate 100 performed according to one aspect of the invention and its modified embodiments.

According to one aspect of the invention and as shown in Figure 1, a substrate 100 is provided, having at least one free surface 110, on which is then deposited a series of layers in order to form a coating or a plating for the substrate 100. A first layer 101 of a first material other than that forming the substrate 100 is deposited on the free surface 110 of the base substrate 100. A second layer 102 of a second material, different from the materials forming the substrate 100 and the first layer 101, is in its turn deposited on the surface 109 of the first layer 101. A third layer 103 of a third material is then deposited on the surface 106 of the second layer 102, the material forming the third layer 103 being in its turn different from the materials used respectively for the substrate 100, the first layer 101 and the second layer 102. The three layers 101, 102, 103 deposited on the free surface 110 of the substrate 100 thus form a multilayer structure 105.

According to one aspect of the invention, a fourth layer 104 is deposited on the surface 107 of the third layer 103, as shown in Figure 1. The material of the fourth layer 104 is so selected as to avoid the oxidation at least of the surface 107 of the third layer 103. The resulting structure 120 before reflow therefore comprises the substrate 100, the multilayer structure 105 and a protective layer 104 as described above. Finally the exposed surface 108 of the fourth layer 104 of the structure 120 is subjected to a thermal treatment so as to perform a reflow of at least a part of the third layer 103 and of the second layer 102.

According to different modified embodiments of the invention, in the example embodiment shown in Figure 1, it is possible to adjust the selection of the materials, particularly their properties in order to optimise control of the reflow and of the final product. Thus, it is possible to select the material of the fourth layer 104, i.e. the protective layer against oxidation, so that it does not mix with any of the layers 101, 102, 103 of the multilayer structure 105 during reflow. It is also preferable to select the fourth material with a specific heat 2 to 3 times higher than that of the second and third materials forming the second layer 102 and the third layer 103 respectively. Thus the fourth layer 104 can adequately conduct heat towards the surface 107 of the third layer 103 in order to perform an at least partial, or even total, reflow of the third layer 103.

In the embodiment shown in Figure 1, it is also possible according to other modifications of the invention, to select the material of the third layer 103 with the lowest melting point of the melting points of the first, second and third materials forming the first 101, second 102 and third 103 layers respectively. This modified embodiment can particularly be combined with a second layer 102, the material of which has a melting temperature 1.5 to 3 times greater than that of the material of the third layer 103. Similarly, the substrate 100 and/or the material of the first layer 101 can be selected with a respective melting temperature at least 2 to 3 times higher than the melting temperature of the material of the second layer 102. The temperature of the reflow step can then be optimised depending on the selection of the materials of the first 101, second 102 and third 103 layers, as well as of the material of the protective layer 104. In the example embodiment of a process for coating the substrate 100 shown in Figure 1, it is advantageous to select a reflow temperature 1.5 to 3 times higher than the melting temperature of the material of the third layer 103, 0.8 to 1.5 times higher than the melting temperature of the material of the second layer 102, and less than or equal to the melting temperature of the material of the first layer 101 and/or of the substrate 100.

Figure 2 shows an example of the treatment of a structure 220 obtained by a process according to the example of the embodiment shown in Figure 1. The structure 220 is therefore in every point analogous to the structure 120. In particular, the structure 220 comprises a substrate 200, a first layer 201, a second layer 202 and a third layer 203, corresponding respectively to the substrate 100 and to the layers 101, 102, 103 of the example shown in Figure 1. The three layers 201, 202, 203 form a multilayer structure 205 similar to the structure 105 shown in Figure 1, and on which is deposited a protective layer 204 analogous to the layer 104 of the first example of an embodiment. The description of the process up to obtaining the structure 220 will therefore be omitted and reference should be made back to the description of Figure 1 for more detail.

Similarly, Figure 3 shows another example of the treatment of a structure 320 obtained by a process according to the example of the embodiment shown in Figure 1. The structure 320 is in every point analogous to the structures 120, 220 of the examples of embodiments shown in Figures 1 and 2. It therefore comprises a substrate 300, a first layer 301, a second layer 302 and a third layer 303, corresponding respectively to the substrate 100 and to the layers 101, 102, 103 of the example shown in Figure 1, and to the substrate 200 and to the layers 201, 202, 203 of the example shown in Figure 2. The three layers 301, 302, 303 form a multilayer structure 305 similar to the structures 105, 205 shown in Figures 1 and 2, and on which is deposited a protective layer 304 analogous to the layers 104, 204 of the two first examples of embodiments. The description of the process up to obtaining the structure 320 will therefore be omitted and reference should be made back to Figure 1 for more detail.

In the examples shown in Figures 2 and 3, the coating process shown in Figure 1 is applied to the coating of press-fit contact terminals for printed circuits. The substrates 200, 300 are made of copper, a material of which the melting temperature is approximately 1085 °C. It is nevertheless possible for these contacts to use materials other than copper, such as for example stainless steels or aluminium. The thickness of the substrates 200, 300 is not critical for the inventive process, but it should be noted that in the particular case of press-fit contact terminals for printed circuits, the thickness of the copper to be plated is generally less than 1 mm, of the order of 0.64 mm.

Tin is commonly used for the plating of such terminals. In the examples of embodiments shown in Figures 2 and 3, the invention will be used in order to provide a coating which avoids the formation of tin whiskers for the terminals of press-fit contacts 200, 300. According to modified embodiments of the invention, the materials of the respective first, second and third layers 201, 202, 203 and 301, 302, 303 of structures 220, 320 before reflow, such as shown in Figures 2 and 3, are metallic materials, particularly elementary metals, as opposed to alloys. In both cases, the first layer 201, 301 is made of nickel, the second layer 202, 302 is made of zinc, and the third layer 203, 303 is made of tin. The thickness of the first layer 201, 301 in the examples shown in Figures 2 and 3 is between 0.05 µm and 5 µm. In the examples described below, the thickness of the first layer 201, 301, i.e. the layer of nickel, is particularly approximately 1.3 µm. The thickness of the second layer 202, 302, i.e. the layer of zinc, is within the range from 0.05 µm to 5 µm. The thickness of the third layer 203, 303, i.e. the layer of tin, is for its part within the range from 0.05 µm to 2.5 µm.

The melting temperatures of nickel, approximately 1455 °C, of zinc, approximately 420 °C, and of tin, approximately 232 °C, are therefore such that the respective first, second and third layers 201, 202, 203 and 301, 302, 303 display the properties permitting optimisation of the control of the reflow step such as described in relation to the embodiment shown in Figure 1. Thus in the embodiments shown in Figures 2 and 3, the material of the third layer 203, 303, i.e. tin, is that having the lowest melting point. The material of the second layer 202, 302, i.e. zinc, has a melting temperature 1.5 to 3 times greater than that of the tin forming the third layer 203, 303. Similarly, the material of the substrate 200, 300, i.e. copper, and the material of the first layer 201, 301, i.e. nickel, have a respective melting temperature at least 2 to 3 times higher than the melting temperature of the material of the second layer 202, 302, i.e. zinc.

According to the invention, the protective layer 204, 304 of the structures 220, 320 of the embodiments shown in Figures 2 and 3 is a mixture of graphite powder and of microcrystalline active carbon. Moreover, graphite has a specific heat of approximately 0.71 J·g⁻¹·K⁻¹, while that of tin is approximately 0.227 J·g⁻¹·K⁻¹, that of zinc is approximately 0.388 J·g⁻¹·K⁻¹, and that of nickel is approximately 0.444 J·g⁻¹·K⁻¹. The specific heat of the material of the protective layer 204, 304 is therefore selected from 2 to 3 times higher than that of the materials of the three respective layers 201, 202, 203 and 301, 302, 303 forming the multilayer structures 205, 305 of the structures 220, 320. A mixture of 80% to 95% of graphite and the remainder of microcrystalline active carbon, particularly of 90% graphite and 10% microcrystalline active carbon, has proved to have advantageous properties in the role of protection against oxidation and of conduction of heat from the protective layer 204, 304 during the step of reflow of the multilayer structures 205, 305 described here for the embodiments shown in Figures 2 and 3 respectively.

In the examples of embodiments shown in Figures 2 and 3, the temperature of the reflow step has been able to be optimised depending on the selection of the materials of the first 201, 301, second 202, 302 and third 203, 303 respective layers, as well as of the material of the protective layer 204, 304. In both cases, it has proved advantageous to choose to apply a temperature from 1.5 to 3 times higher than the melting temperature of tin, i.e. the material of the third layer 203, 303, from 0.8 to 1.5 times higher than the melting temperature of the zinc material, i.e. the material of the second layer 202, 302, and less than or equal to the melting temperature of nickel, i.e. the material of the first layer 201, 301 and of copper, i.e. the material of the substrate 200, 300 to be plated. Moreover, a continuous reflow process also permitted shorter treatment durations than those known from the state of the art for the deposited thicknesses and the selected applied temperatures. Thus, a temperature of at least 350 °C, particularly within the range from 350 °C to 600 °C, more particularly within the range from 380 °C to 580 °C, and still more particularly from 400 °C to 550 °C, permitted improved reflow, particularly by permitting a duration of the reflow step between 1 and 15 seconds approximately, particularly between 2 seconds and 10 seconds, and more particularly between 3 seconds and 7 seconds.

Depending on the thicknesses of tin and of zinc deposited respectively for the third layer 203, 303 and the second layer 202, 302, in other words the mass composition of each of them in the final reflowed alloy 211, 311, the melting temperature of this alloy is going to vary according to the phase diagram. The larger the proportion of zinc, the higher the melting temperature will have to be in order to reflow all of the layers of tin 203, 303 and of zinc 202, 302 deposited and conversely in the case of a small proportion of zinc. Moreover, the use in two superimposed layers 202, 302 and 203, 303 of two alloys with a low melting point (tin 232 °C and zinc 420 °C), having a eutectic in this case at 8.9% of zinc, provides at their interface 206, 306 the lowest melting temperature of the proposed system, or in the case of the embodiments shown in Figures 2 and 3, approximately 200 °C. Management of the different thicknesses deposited then gives the possibility of completely reflowing or not reflowing the sub-layer 202, 302 of zinc.

In the embodiment shown in Figure 2, the starting mass composition comprises from 85% to 95% of tin for 5% to 15% of zinc, particularly 90% of tin for 10% of zinc. The thickness of the layer of zinc 202 can then be for example approximately 0.1 µm, and the thickness of the tin layer 203 can be for example approximately 0.5 µm. The melting temperature of the interface 206 between the layer of zinc 202 and the layer of tin 203 is, after rapid diffusion of the zinc, approximately 198 °C, and corresponds to the melting temperature of the binary eutectic Sn (91.1%)-Zn (8.9%). The melting temperature of the alloy Sn(90%)-Zn(10%), as a whole, is around 200 °C. The reflow temperature is selected at 550 °C and is applied continuously for a duration of approximately 3 seconds so that complete reflow, from the two fronts or interfaces 206 and 207, of the layers of tin 203 and of zinc 202 is effected. There therefore remains no buffer layer of the starting layer of zinc 202. The initial layer of nickel 201, which forms a diffusion barrier to prevent the diffusion of the copper from the substrate 200 towards the more outer layers 202, 203, is partially dissolved to form a third alloy element with the tin and the zinc, thus forming the multiphase, also known as polyphase, solidification structure 211, after reflow, comprising an intermetallic tin-zinc-nickel compound. The remainder 201' of the starting layer of nickel 201 continues to form a diffusion barrier relative to the substrate 200. The protective layer 204 made of a mixture of graphite and active carbon does not mix with the other layers during reflow and avoids oxidation particularly of the surface 207 of the third layer 203 as well as of the subjacent layers 202, 201, 200.

Finally, the embodiment shown in Figure 2 comprises a step of removal of the protective layer 204 once the desired final alloy 211 has been obtained. The protective layer 204 was a mixture of graphite and active carbon, it is sufficient to tap, or even to simply blow, on the structure 221 after reflow to cause crumbling or breaking of the protective layer 204, which is less resistant to shocks than the alloy 211 and the barrier layer 201' forming the final coating of the substrate 200. The final product 222 is therefore composed of the substrate 200 plated with a coating 223 composed of the remainder of the barrier layer 201 and of the multiphase alloy 211. It has been found that the coating 223, particularly the multiphase alloy 211, thus created has thixotropic properties, of which advantage can be taken in the context of plating of the terminals of press-fit contacts.

It is possible to create modified embodiments of the alloy 223 comprising a polyphase structure 211 similar to that described in relation to the embodiment shown in Figure 2, particularly having the same type of thixotropic properties. Thus, another starting mass composition can comprise for example from 69% to 79% of tin for 21% to 31% of zinc, particularly 74% of tin for 26% of zinc. The respective thicknesses of the layers of zinc 202 and of tin 203 can then be for example approximately 0.4 µm and 0.15 µm respectively. A temperature of approximately 500 °C can then be applied continuously for a duration of approximately 5 seconds.

In the embodiment shown in Figure 3, the starting mass composition this time comprises from 5% to 15% of tin for 85% to 95% of zinc, particularly 10% of tin for 90% of zinc. The respective thickness of the layers of zinc 302 and of tin 303 can be of the order of 0.5 µm. The melting temperature of the interface 306 between the layer of zinc 302 and the layer of tin 303 is, after rapid diffusion of the zinc, approximately 198 °C, and corresponds to the melting temperature of the binary eutectic Sn(91.1%)-Zn(8.9%). The melting temperature of the alloy Sn(10%)-Zn(90%), as a whole, is around 400 °C. The reflow temperature is selected at approximately 500 °C and is applied continuously for a duration of approximately 3 seconds so that the entire layer of tin 303 is completely reflowed, from the two fronts or interfaces 306 and 307, but the layer of zinc 302 is only partially reflowed, thus forming the tin-zinc multiphase layer 311 resting on a buffer layer 302' of zinc, corresponding to the remaining part of the starting layer of zinc 302. Another difference with the embodiment shown in Figure 2 is that the diffusion barrier layer of nickel 301 is not reflowed in this case. Depending on the duration and temperature of the thermal treatment, it is possible to obtain different structures of the material for the layer 311. For the example described here, the layer 311 is a biphase solidification structure formed of globular zinc surrounded by tin with a small diffusion zone between these two reflowed elements. However variations of +10 °C to +30 °C relative to the initially selected temperature can produce the same type of layers 311, 302' but with different properties for a same initial mass composition. Thus, with greater diffusion, it is possible to obtain a eutectic structure with pro-eutectic precipitation of zinc, of acicular form. A still greater increase in temperature, for example of +50 °C, can bring about the total reflowing of the sub-layer of zinc 302 instead of leaving the buffer layer 302'. As for the case shown in Figure 2, the protective layer 304 made of a mixture of graphite and active carbon does not mix with the other layers during reflow and avoids oxidation particularly of the surface 307 of the third layer 303 as well as of the subjacent layers 302, 301, 300 during the treatment.

Like the embodiment shown in Figure 2, that shown in Figure 3 also comprises the removal of the protective layer 304 from the structure 321 once the desired final alloy 311 has been obtained following the thermal treatment of the structure 320. This step is similar to that described for the layer 204 shown in Figure 2. Reference should therefore be made back to the preceding description. As for the case shown in Figure 2, in the embodiment shown in Figure 3, the coating 323, particularly the multiphase layer 311, of the final product 322 has thixotropic properties, which improve the insertion process of press-fit contacts in printed circuit boards.

As for the second embodiment shown in Figure 2, it is possible to create modifications of the third embodiment, for example by varying the starting mass composition of the layers deposited and by adjusting the temperature and the duration of the reflow step. Depending on the composition selected, the modifications can lead to the same type of tin-zinc biphase structure 311 having the same type of properties, particularly thixotropic properties, resting if necessary on a larger or smaller buffer layer 302' of zinc depending on the quantity of zinc reflowed.

Thus, for example, it is possible to use a mass composition comprising for example from 42% to 52% of tin for 48% to 58% of zinc, particularly 47% of tin for 53% of zinc. The respective thicknesses of the layers of zinc 302 and of tin 303 can then for example be approximately 0.6 µm and 0.7 µm respectively. A reflow step performed at a temperature of approximately 400 °C applied continuously for a duration of approximately 7 seconds results in a globular biphase tin-zinc structure 311 resting on a buffer layer 302' of zinc of reduced thickness relative to the initial layer of zinc 302.

In another example, non-limiting like the preceding ones, it is possible to use a mass composition comprising for example from 18% to 28% of tin for 72% to 82% of zinc, particularly 23% of tin for 77% of zinc. The respective thicknesses of the layers of zinc 302 and of tin 303 can then be for example approximately 0.25 µm and 0.85 µm respectively. A reflow step performed at a temperature of approximately 460 °C applied continuously for a duration of approximately 5 seconds this time results in a globulo-acicular biphase tin-zinc structure 311 resting on a buffer layer 302' of zinc of reduced thickness relative to the initial layer of zinc 302.

A finish of binary eutectic type with pro-eutectic zinc, or tin and globular zinc, like the layer 311 of the embodiment shown in Figure 3, will be favourable to the formation of cold weld on a circuit of tinned finish. In fact, during the press insertion of the contact, here represented by the substrate 300, in the hole of the printed circuit, the pressure contacting of the tin of the coating of the circuit with the pro-eutectic zinc 311 of the contact 300 will permit the formation of the tin-zinc binary eutectic. The melting point of this, lower than that of the two elements placed in contact, will lead to the melting of the interface and the formation of micro-welds between the contact 300 and the circuit.

As a modification to the preceding embodiments, it is possible to apply the process described in relation to Figure 1 to silver-plated printed circuits rather than to copper circuits. For a same solidification structure 211, 311, a silver-plated printed circuit will not have the same ability to form micro-welds. It does not form a eutectic with the zinc and the melting temperature of the tin-silver eutectic is approximately 221 °C, or very close to that of pure tin. The use of the process described in the present invention allows on the other hand the use of alloy elements such as antimony, forming with 44% by mass a eutectic with a melting point of approximately 485 °C with silver. In this case, it is advantageous to replace the zinc layer 202, 302 with antimony as a sub-layer in order to allow, after reflow, the formation of the globular islets of antimony favourable to micro-welds with the silver of the circuit. This structure also allowing the structural conditions for stopping the formation of whiskers to be satisfied.

The internal stresses emanating from the operations of shaping the contact 200, 300 by die-stamping will be partially relaxed during reflow. From this results another advantage given by this structure 211, 311 and this solidification process which is that the presence of globular zinc or acicular pro-eutectic zinc permits, by formation of a eutectic with a low melting point, a cold micro-weld effect between the structures 211, 311 and the surface alloy of a printed circuit, and as a result the forces for extracting a press-fit contact 200, 300 from a tinned circuit are greater than the insertion forces, which improves the holding in place of the press-fit contacts 200, 300.

The invention therefore permits the creation of a surface 207, 307 without whiskers and preventing the formation of these, and can be used for coatings of terminals of press-fit contacts 200, 300. The solidification structures 211, 311 and their modifications obtained at high temperature by the inventive process consist of several phases, elements, more or less stable precipitates, gradients of concentration in the thickness, the grains and inter-granulars opposing movements of dislocations in the outermost layer of the coating, corresponding to the layers 211 and 311 in the examples described above, with the advantage of slowing, or even preventing, diffusion phenomena which generate whiskers. The whole of the treatment of the inventive process permits control of the fineness, the distribution and the quantity of the precipitates and phases formed. Another advantage of the process of the present invention is to make it possible, depending on the solidification structure 211, 311 selected and the thicknesses deposited, to avoid dewetting of the fused alloy.

In the case in which the third layer 103, 203, 303 is made of tin, a layer 102, 202, 302 of zinc can be used as a coating sub-layer 102, 202, 302 and can be reflowed with the layer of tin 103, 203, 303. The invention then makes it possible to perform the reflow of the layers of tin 103, 203, 303 and of zinc 102, 202, 302 into a tin-zinc multilayer coating 211, 311 by thermal contact at high temperature on a protective layer 104, 204, 304 against oxidation comprising a mixture of graphite. It is possible to initiate the reflowing in a selective manner at the tin-zinc interface 106, 206, 306, while reflowing the surface 107, 207, 307 of the layer of tin 103, 203, 303 before solid-solid diffusion towards the outer surface of the coating. In this manner it is possible to create a non-porous, smooth and hard surface 211, 311 able to be used for the coating of base substrates 100, 200, 300, for example in the case of contacts of electronic components. It is also possible to control a residual buffer sub-layer of zinc 302', to have a multiphase solidification structure 211, 311 comprising precipitates which block the movement of dislocations, to partially, or even totally, relax the stresses present in the substrate 100, 200, 300 and in the coating layers 211, 311 by means of temperature effects. The process is in addition quicker than known processes of the state of the art for a cost which is also reduced. The sub-layer 101, 201, 201', 301 of nickel can be used and partially mixed with the liquid tin-zinc alloy 211 in order to create a surface without whiskers with advantageous properties with regard to corrosion. In the case of the tin-zinc mixture and/or of the sub-layer 101, 201, 301 of nickel, the alloy 211, 311 created has more advantageous thermal properties than a conventional alloy of pure tin. It is possible particularly to obtain an alloy 211, 311 having thixotropic properties, therefore able to facilitate and thus improve the insertion of the press-fit contacts in the holes of the printed circuit board by being destructured under the stresses during insertion, then by being restructured once the insertion has been performed and the stresses relaxed, while retaining the advantageous properties of the final product with regard to the prevention of whiskers. The coefficient of friction and the mechanical and thermal properties of the surfaces 207, 307 thus obtained are improved relative to the known tin coatings of the state of the art.

It is therefore possible to obtain coatings 211, 311 without whiskers and which prevent the subsequent formation of whiskers, particularly tin whiskers, usable for the plating of pin terminals of press-fit contacts, but also for the holes of the printed circuit boards intended to receive press-fit contact pins, for the platings of the printed circuits themselves or of other printed circuit elements, or more broadly for any product vulnerable to whiskers. Moreover, the use of the inventive process to plate printed circuit elements as well as its possible modifications and combinations, and the use of the inventive coating and its modified embodiments for example in the case of plating of press-fit contacts, advantageously permits relaxation of the internal stresses and stabilisation of the metallurgical structure of the plated elements and of their coating in order to guarantee their performance. Particularly, the insertion forces of press-fit contacts in corresponding holes of printed circuits are stabilised during the lifetime of the product.

## Claims

1. A process for coating a substrate, in which:
a substrate (100) is provided having at least one free surface (110);
a first layer (101) of a first material is deposited on the free surface (110) of the substrate (100);
a second layer (102) of a second material, different from the first material, is deposited on the first layer (101);
a third layer (103) of a third material, different from the first and second materials, is deposited on the second layer (102);
**characterised in that**
the process comprises in addition the deposition of a protective layer (104) of a fourth material, different from the first, second and third materials, on the third layer (103); and the reflow of at least the second (102) and third (103) layers from the first (101), second (102) and third (103) layers, by transfer of heat by thermal contact on the protective layer (104), the protective layer (104) avoiding oxidation at least of the third layer (103); and **in that**
the material of the protective layer (104) is so selected that it does not mix with the first (101), second (102) and third (103) layers during the reflow step.

2. The process for coating a substrate according to claim 1, in which the temperature of the reflow step is 1.5 to 3 times higher than the melting temperature of the third material (103), 0.8 to 1.5 times higher than the melting temperature of the second material (102), and is less than or equal to the melting temperature of the first material (101) and/or of the substrate (100).

3. The process for coating a substrate according to any one of the preceding claims, in which the fourth material (104) is a mixture of graphite powder and of microcrystalline active carbon, particularly a mixture of 80% to 95% of graphite and the remainder of microcrystalline active carbon, more particularly a mixture of 90% of graphite and of 10% of microcrystalline active carbon.

4. The process for coating a substrate according to any one of the preceding claims, in which the first (101), second (102) and third (103) materials are or comprise metallic materials particularly elementary metals.

5. The process for coating a substrate according to any one of the preceding claims, in which the third material (103) is the material having the lowest melting point of the melting points of the first (101), second (102) and third (103) materials.

6. The process for coating a substrate according to any one of the preceding claims, in which the second material (102) has a melting temperature 1.5 to 3 times greater than that of the third material (103).

7. The process for coating a substrate according to any one of the preceding claims, in which the substrate (100) and/or the first material (101) have a melting temperature at least 2 to 3 times higher than the melting temperature of the second material (102).

8. The process for coating a substrate according to any one of the preceding claims, in which the fourth material (104) has a specific heat 2 to 3 times higher than that of the second (102) and third (103) materials.

9. The process for coating a substrate according to any one of the preceding claims, in which the first material (101) is or comprises nickel, and/or the second material (102) is or comprises zinc or antimony, and/or the third material (103) is or comprises tin and/or silver.

10. The process for coating a substrate according to any one of the preceding claims, in which the temperature of the reflow step is at least 350 °C, particularly within the range from 350 °C to 600 °C, more particularly within the range from 380 °C to 580 °C, and still more particularly within the range from 400 °C to 550 °C.

11. The process for coating a substrate according to claim 10 in which the duration of the reflow step varies at least between 1 second and 15 seconds, particularly between 2 seconds and 10 seconds, and more particularly between 3 seconds and 7 seconds.

12. The process for coating a substrate according to any one of the preceding claims, in which the thickness of the first layer (101) is within the range from 0.05 µm to 5 µm, and/or the thickness of the second layer (102) is within the range from 0.05 µm to 5 µm, and/or the thickness of the third layer (103) is within the range from 0.05 µm to 2.5 µm.

13. The process for coating a substrate according to any one of the preceding claims, comprising in addition the removal of the protective layer (104) after the reflow step.

## Patentansprüche

1. Prozess zur Beschichtung eines Substrats, wobei:
ein Substrat (100) mit mindestens einer freien Oberfläche (110) bereitgestellt wird;
eine erste Schicht (101) eines ersten Materials auf der freien Oberfläche (110) des Substrats (100) abgeschieden wird;
eine zweite Schicht (102) eines zweiten Materials, das sich von dem ersten Material unterscheidet, auf der ersten Schicht (101) abgeschieden wird;
eine dritte Schicht (103) eines dritten Materials, das sich von dem ersten und dem zweiten Material unterscheidet, auf der zweiten Schicht (102) abgeschieden wird;
**dadurch gekennzeichnet, dass**
der Prozess zusätzlich umfasst: die Abscheidung einer Schutzschicht (104) aus einem vierten Material, das sich von dem ersten, dem zweiten und dem dritten Material unterscheidet, auf der dritten Schicht (103); und das Aufschmelzen zumindest der zweiten (102) und der dritten (103) Schicht aus der ersten (101), der zweiten (102) und der dritten (103) Schicht durch Wärmeübertragung mittels Wärmekontakt auf der Schutzschicht (104), wobei die Schutzschicht (104) eine Oxidation zumindest der dritten Schicht (103) verhindert; und
das Material der Schutzschicht (104) so ausgewählt ist, dass es sich nicht mit der ersten (101), der zweiten (102) und der dritten (103) Schicht während des Aufschmelzschrittes vermischt.

2. Prozess zur Beschichtung eines Substrats nach Anspruch 1, wobei die Temperatur des Wiederaufschmelzschrittes 1,5- bis 3-mal höher ist als die Schmelztemperatur des dritten Materials (103), 0,8 bis 1,5-mal höher als die Schmelztemperatur des zweiten Materials (102) ist und niedriger oder gleich der Schmelztemperatur des ersten Materials (101) und/oder des Substrats (100) ist.

3. Prozess zur Beschichtung eines Substrats nach einem der vorhergehenden Ansprüche, wobei das vierte Material (104) eine Mischung aus Graphitpulver und aus mikrokristallinem aktiven Kohlenstoff ist, insbesondere eine Mischung aus 80 % bis 95 % aus Graphit und aus dem restlichen Anteil als mikrokristalliner aktiver Kohlenstoff, und noch bevorzugter eine Mischung aus 90 % aus Graphit und 10 % aus mikrokristallinem aktiven Kohlenstoff ist.

4. Prozess zur Beschichtung eines Substrats nach einem der vorhergehenden Ansprüche, wobei das erste (101), das zweite (102) und das dritte (103) Material metallische Materialien, insbesondere elementare Metalle, sind oder aufweisen.

5. Prozess zur Beschichtung eines Substrats nach einem der vorhergehenden Ansprüche, wobei das dritte Material (103) ein Material mit dem niedrigsten Schmelzpunkt der Schmelzpunkte des ersten (101), des zweiten (102) und des dritten (103) Materials ist.

6. Prozess zur Beschichtung eines Substrats nach einem der vorhergehenden Ansprüche, wobei das zweite Material (102) eine Schmelztemperatur hat, die 1,5- bis 3-mal höher ist als diejenige des dritten Materials (103).

7. Prozess zur Beschichtung eines Substrats nach einem der vorhergehenden Ansprüche, wobei das Substrat (100) und/oder das erste Material (101) eine Schmelztemperatur haben, die mindestens 2- bis 3-mal höher ist als die Schmelztemperatur des zweiten Materials (102).

8. Prozess zur Beschichtung eines Substrats nach einem der vorhergehenden Ansprüche, wobei das vierte Material (104) eine spezifische Wärme hat, die 2- bis 3-mal höher ist als diejenige des zweiten (102) und des dritten (103) Materials.

9. Prozess zur Beschichtung eines Substrats nach einem der vorhergehenden Ansprüche, wobei das erste Material (101) Nickel ist oder aufweist, und/oder das zweite Material (102) Zink oder Antimon ist oder aufweist, und/oder das dritte Material (103) Zinn und/oder Silber ist oder aufweist.

10. Prozess zur Beschichtung eines Substrats nach einem der vorhergehenden Ansprüche, wobei die Temperatur des Wiederaufschmelzschrittes mindestens 350 °C beträgt, insbesondere im Bereich von 350 °C bis 600 °C liegt, noch bevorzugter innerhalb des Bereichs von 380 °C bis 580 °C liegt, und höchst bevorzugt im Bereich von 400 °C bis 550 °C liegt.

11. Prozess zur Beschichtung eines Substrats nach Anspruch 10, wobei die Dauer des Wiederaufschmelzschrittes zwischen 1 Sekunde und 15 Sekunden, insbesondere zwischen 2 Sekunden und 10 Sekunden und bevorzugt zwischen 3 Sekunden und 7 Sekunden variiert.

12. Prozess zur Beschichtung eines Substrats nach einem der vorhergehenden Ansprüche, wobei die Dicke der ersten Schicht (101) im Bereich von 0,05 µm bis 5 µm liegt, und/oder die Dicke der zweiten Schicht (102) im Bereich von 0,05 µm bis 5 µm liegt, und/oder die Dicke der dritten Schicht (103) im Bereich von 0,05 µm bis 2,5 µm liegt.

13. Prozess zur Beschichtung eines Substrats nach einem der vorhergehenden Ansprüche, das zusätzlich die Entfernung der Schutzschicht (104) nach dem Wiederaufschmelzschritt umfasst.

## Revendications

1. Procédé de revêtement d'un substrat, dans lequel :
un substrat (100) est fourni qui possède au moins une surface libre (110) ;
une première couche (101) d'un premier matériau est déposée sur la surface libre (110) du substrat (100) ;
une deuxième couche (102) d'un deuxième matériau, différent du premier matériau, est déposée sur la première couche (101) ;
une troisième couche (103) d'un troisième matériau, différent des premier et deuxième matériaux, est déposée sur la deuxième couche (102) ;
**caractérisé en ce que**
le procédé comprend en outre le dépôt d'une couche protectrice (104) d'un quatrième matériau, différent des premier, deuxième et troisième matériaux, sur la troisième couche (103) ; et la refusion d'au moins les deuxième (102) et troisième (103) couches parmi les première (101), deuxième (102) et troisième (103) couches, par transfert de chaleur par contact thermique sur la couche protectrice (104), la couche protectrice (104) évitant l'oxydation d'au moins la troisième couche (103) ; et **en ce que**
le matériau de la couche protectrice (104) est sélectionné de sorte qu'il ne se mélange pas avec les première (101), deuxième (102) et troisième (103) couches pendant l'étape de refusion.

2. Procédé de revêtement d'un substrat selon la revendication 1, dans lequel la température de l'étape de refusion est 1,5 à 3 fois plus élevée que la température de fusion du troisième matériau (103), 0,8 à 1,5 fois plus élevée que la température de fusion du deuxième matériau (102) et inférieure ou égale à la température de fusion du premier matériau (101) et/ou du substrat (100).

3. Procédé de revêtement d'un substrat selon l'une quelconque des revendications précédentes, dans lequel le quatrième matériau (104) est un mélange de poudre de graphite et de charbon actif microcristallin, en particulier un mélange de 80 % à 95 % de graphite et le reste étant du charbon actif microcristallin, plus particulièrement un mélange de 90 % de graphite et de 10 % de charbon actif microcristallin.

4. Procédé de revêtement d'un substrat selon l'une quelconque des revendications précédentes, dans lequel les premier (101), deuxième (102) et troisième (103) matériaux sont ou comprennent des matériaux métalliques, en particulier des métaux élémentaires.

5. Procédé de revêtement d'un substrat selon l'une quelconque des revendications précédentes, dans lequel le troisième matériau (103) est le matériau ayant le point de fusion le plus bas parmi les points de fusion des premier (101), deuxième (102) et troisième (103) matériaux.

6. Procédé de revêtement d'un substrat selon l'une quelconque des revendications précédentes, dans lequel le deuxième matériau (102) a une température de fusion 1,5 à 3 fois plus élevée que celle du troisième matériau (103).

7. Procédé de revêtement d'un substrat selon l'une quelconque des revendications précédentes, dans lequel le substrat (100) et/ou le premier matériau (101) ont une température de fusion au moins 2 à 3 fois plus élevée que la température de fusion du deuxième matériau (102).

8. Procédé de revêtement d'un substrat selon l'une quelconque des revendications précédentes, dans lequel le quatrième matériau (104) a une chaleur spécifique 2 à 3 fois plus élevée que celle des deuxième (102) et troisième (103) matériaux.

9. Procédé de revêtement d'un substrat selon l'une quelconque des revendications précédentes, dans lequel le premier matériau (101) est ou comprend du nickel, et/ou le deuxième matériau (102) est ou comprend du zinc ou de l'antimoine, et/ou le troisième matériau (103) est ou comprend de l'étain et/ou de l'argent.

10. Procédé de revêtement d'un substrat selon l'une quelconque des revendications précédentes, dans lequel la température de l'étape de refusion est d'au moins 350 °C, en particulier dans la plage de 350 °C à 600 °C, plus particulièrement dans la plage de 380 °C à 580 °C, et encore plus particulièrement dans la plage de 400 °C à 550 °C.

11. Procédé de revêtement d'un substrat selon la revendication 10, dans lequel la durée de l'étape de refusion varie au moins entre 1 seconde et 15 secondes, en particulier entre 2 secondes et 10 secondes, et plus particulièrement entre 3 secondes et 7 secondes.

12. Procédé de revêtement d'un substrat selon l'une quelconque des revendications précédentes, dans lequel l'épaisseur de la première couche (101) est dans la plage de 0,05 µm à 5 µm, et/ou l'épaisseur de la deuxième couche (102) est dans la plage de 0,05 µm à 5 µm, et/ou l'épaisseur de la troisième couche (103) est dans la plage de 0,05 µm à 2,5 µm .

13. Procédé de revêtement d'un substrat selon l'une quelconque des revendications précédentes, comprenant en outre l'élimination de la couche protectrice (104) après l'étape de refusion.
